# EUROPEAN PATENT APPLICATION

(11) **EP 4 134 693 A1**
(43) Date of publication of application: **15.02.2023**
(21) Application number: 21190560.9
(22) Date of filing: 10.08.2021
(51) Int. Cl.: G01R 33/385

(54) **SHIELDED GRADIENT COIL ASSEMBLY**

(71) Applicant: Koninklijke Philips N.V., 5656 AG Eindhoven (NL)
(72) Inventor: VAN HEST, Augustinus Bertus Petrus, 5656 AE Eindhoven (NL); KONIJN, Jan, 5656 AE Eindhoven (NL); OVERWEG, Johannes Adrianus, 5656 AE Eindhoven (NL); TERMEER, Martijn Krelis, 5656 AE Eindhoven (NL)
(74) Representative: Philips Intellectual Property & Standards

(57) **Abstract**

A shielded gradient coil assembly (40) to generate a gradient magnetic field, the assembly comprises a plurality of radially inner and outer coaxial cylindrical surfaces (11, 12), a gradient field coil arrangement on the radially inner cylindrical surfaces (11) including a longitudinal gradient field coil system (131) having one or more axial circumferential electrically conducting hollow z-field windings having a smaller transverse cross-section and a transverse gradient field coil system (132) having hollow (x,y)-field electrical conductors having a smaller transverse cross-section and arranged as saddle coils on the surfaces of the inner cylindrical surfaces (11). A gradient shield coil arrangement is provided on the radially outer cylindrical surfaces (12) including a longitudinal gradient shield coil system (141) having one or more axial circumferential electrically conducting hollow z-shield windings having a larger transverse cross-section and a transverse gradient shield coil system (142) having solid electrical conductors arranged as saddle coils on the surfaces of the outer cylindrical surfaces (12). In this way an optimum combination is achieved of efficient direct and indirect cooling of the conductors while keeping eddy current effects at a low level.

## Description

### FIELD OF THE INVENTION

The invention pertains to a shielded gradient assembly which is configured to generate gradient magnetic fields in various directions in an examination zone. The shielded gradient system comprises a gradient field coil arrangement which generates the gradient magnetic fields and a gradient shield coil arrangement that compensates the gradient magnetic fields outward form the shielded gradient assembly.

### BACKGROUND OF THE INVENTION

Such a shielded gradient assembly is known from the international application WO2005/0431185.

The known shielded gradient system has a shield coil with a z-coil with hollow conductors for direct cooling purposes and water flows through the hollow conductors. The z-coil is sandwiched between x-coils and y-coils of the shield coil. These x-coils and y-coils are indirectly cooled by the z-coil.

### SUMMARY OF THE INVENTION

An object of the invention is to provide a shielded gradient assembly that has an optimised performance as compared to the known shielded gradient assembly.

This object is achieved by the shielded gradient assembly of Claim 1.

The shielded gradient coil assembly of the invention has the gradient field coil arrangement's electrical conductors and the gradient shield coil arrangement's electrical conductors arranged on respective inner and outer coaxial surfaces. The coaxial cylindrical surface may be physical surfaces, e.g. formed by coil former, or they may be virtual surfaces formed by the shape of self-carrying circumferential or saddle coil conductors. According to the invention, the gradient field coil arrangement has sets of electrical conductors to generate gradient magnetic fields in the longitudinal (z), and two transverse (x,y) directions. The gradient field coil arrangement is provided with hollow electrical conductors of a smaller cross section orthogonal electrical conductor's elongation. For example these hollow electrical conductors have e a cross section of 9-50mm² and a lumen cross section of 6-40mm², good results are achieved for a lumen of 6x6mm rectangular cross sections The smaller hollow electrical conductors may have a rectangular cross section as small as 2.5-3.0 to 3.0x4.0mm. Fluid coolant may be passed through the hollow electrical conductors for direct cooling when electrical current passes though the electrical conductors. The smaller cross section suppresses the generation of eddy currents in the gradient coil. Additionally the generation of eddy currents in in components outside the gradient coils due to switching of the electrical currents, notably when the shielded gradient assembly is operated in a magnet system, for example a superconducting magnet system. The longitudinal gradient shield coil system's axial circumferential electrically conducting hollow z-shield windings have a larger transverse cross-section of about 100, 120 or 200-500mm². In practice the gradient shield coil system's axial circumferential electrically conducting hollow z-shield windings have a transverse cross-section that is more than twice than that of the gradient field coil system's axial circumferential electrically conducting hollow z-shield windings.

An insight of the invention is to employ hollow electrical conductors with direct fluid cooling with smaller cross sections in the gradient field coil arrangement, because there the magnetic flux density is higher. In particular all electrical conductors of the gradient field coil arrangement are formed as hollow conductors. For the shield coil arrangement, the transverse saddle coils may be formed as surface area coils or may formed by solid conductors, saddle coils disposed on or made out of plates. The circumferential coils of the shield coil arrangement have a higher capacity direct fluid cooling with sufficient cooling capacity to also provide indirect cooling the surface area coils. The larger cross section of the hollow circumferential coils of the shield coil arrangement cause a larger susceptibility for eddy current generations, but in the in the gradient shield coil arrangement the magnetic flux is lower so that eddy current generation is reduced. In this way an optimum combination is achieved of efficient direct and indirect cooling of the conductors while keeping eddy current effects at a low level

According to an alternative arrangement, the object of the invention is achieved by the shielded gradient coil assembly defined in Claim 2. In this alternative arrangement solid conductors are employed in the gradient field coil arrangement for the longitudinal field coil arrangement as well as for the gradient shield coil arrangement. In this arrangement cooling of the gradient field coil arrangement is done by electrically non-conductive cooling channels, e.g. plastic tubes, that are arranged between the solid z-field windings and the solid (x,y)- field saddle coil windings.

The alternative configuration of the shield gradient coil assemblies of the invention have in common that different cooling principles for the gradient field coil arrangement and the gradient shield coil arrangement are used, respectively. In particular in the gradient field coil the longitudinal and transverse gradient field coil arrangements are individually cooled, e.g. either by direct fluid cooling through hollow conductors or by the intersperse electrically non-conducting cooling channels, while in the gradient shield coil arrangement the transverse gradient shield coil system is cooled indirectly through the longitudinal shield coil system that is fitted with the larger size hollow conductors.

These and other aspects of the invention will be further elaborated with reference to the embodiments defined in the dependent Claims.

In an embodiment the shielded gradient coil assembly of the invention, the longitudinal gradient shield coil system's electrical conductors are in thermal correspondence with the transverse gradient shield coil system's surface area electrical conductors. This achieves the surface area electrical conductors, that may be formed as saddle coils are indirectly cooled by the cooling capacity of the longitudinal gradient shield coil system's electrical conductors. These latter electrical conductors are hollow conductors though which a fluid coolant, e.g. (demi)water, that actively carries-off heat from the gradient shield coil arrangement.

In an embodiment of the shielded gradient coil assembly, the sets of electrical conductors for generating the (x,y) gradient magnetic fields and the (x,y) shielding gradient magnetic fields are configured such that the sets of field and shield conductors for equal orientations are positioned at about equal radial distances. Thus, for both transverse directions (x,y) about equal radial separation is achieved for the respective sets of electrical conductors, or coil arrangements, for generation of gradient magnetic field and shielding magnetic fields for gradient magnetic fields with the same transverse orientation. That is, the mutual radial distances between the shield coil arrangement and the field coil arrangement are about equal for the x-gradients and the y-gradients. This achieves more comparable or even almost equal performance within the shielded gradient coil assembly of efficiency of the electrical conductors generating field and shield magnetic fields.

In another embodiment of the shielded gradient coil assembly, the transverse gradient shield coil systems has two radially offset sets of surface area electrical conductors for generating shielding gradient magnetic field in respective transverse orientations positioned radially outward relative to the longitudinal gradient shield coil system. That is the sets of electrical conductor for generating the gradient magnetic fields in the transverse x-direction and y-direction, respectively are arranged in parallel adjacent cylindrical surfaces, e.g. as saddle coils. The transverse gradient field coil system has two radially offset saddle coils built-up from hollow electrical conductors. These hollow electrical conductors are smaller sized, so that eddy currents due to gradient switching are suppressed. The eddy current suppression avoids or reduces technical drawbacks such as eddy currents degrade the speed and efficiency of gradient switching; generation error fields and image artefacts. Suppression of eddy currents also reduces heat dissipation into the magnet system's cryostat, so that for non-sealed superconducting magnets boil-off of superconducting coolant (liquid He) for the magnet system's superconducting field coils is reduced.

In another example of the shielded gradient coil assembly, the transverse gradient field coil system's hollow electrical conductors are arranged closer to the examination zone where the patient to be examined may be positioned, than the longitudinal gradient field coil system's circumferential electrical conductors. This spatial configuration optimises the efficiency of the gradient field coil arrangement in that the transverse field coil system is closer to the examination zone (saddle coils being less efficient in nature), while the more efficient longitudinal field coil arrangement is at a larger distance from the examination zone. The efficiency of the gradient field coil arrangement is represented by the ratio of gradient amplitude to applied electrical current strength.

These and other aspects of the invention will be elucidated with reference to the embodiments described hereinafter and with reference to the accompanying drawing wherein

### BRIEF DESCRIPTION OF THE DRAWINGS

Fig. 1 shows part of a cross section in side elevation of a prior art gradient coil;
Fig. 2 shows p[art of a cross section of a side elevation gradient coil of the invention with dedicated cooling channels on the inner main coils;
Fig. 3 shows part of a cross section of a side elevation of the gradient coil with an all hollow conductor design and
Fig. 4 shows part of a cross section of a side elevation of the gradient coil of the gradient coil of the invention with a hybrid cooling layout.

### DETAILED DESCRIPTION OF THE EMBODIMENTS

### Background of the invention

Gradient coils usually are limited in their performance because otherwise the coil can overheat. This heat is generated by Ohmic losses as well as eddy current losses. It is common practice to cool the coil via liquid cooling as such. This is done by several methods.

Add dedicated cooling layers in the gradient coil build up, these layers have cooling channels which extract heat from the coil windings via conduction

Use the coils which run in circumferential direction as a cooling channel by making them hollow and cool in that manner. In cylindrical coils these are the coils responsible of making a gradient field in the axial direction. The saddle coils cool indirectly via conduction to the cooled circumferential coils

Having all conductors directly cooled, using hollow circumferential coils and hollow saddle coils

According to the invention, we created a highly efficient gradient coil, with a unique build-up. Existing gradient coils only have hollow conductors in circumferential direction or have all hollow conductors or have indirect cooling by separate cooling layers. These conventional designs all have significant disadvantages, which are overcome in the design of the invention. This decreases T_{R}'s or waiting times between heavy scans, allowing a higher duty cycle and increasing patient throughput. It also enables use of higher gradient strength, leading to shorter T_{E}'s improving SNR.

We can divide conventional gradient coil cooling concepts into three concepts:
One axis directly cooled, the other axes indirectly cooled as known from the international application WO2005/0431185.

### Pros

Easy to manufacture. The circumferential conductors have a low curvature and are easy to wind.

### Cons

Direct cooling is only in place were the circumferential coils are
The enclosing material needs to have a high thermal conductivity in order to transport heat from the saddle coils to the circumferential coils
The layers in-between the cooled circumferential coils and the saddle coils needs the be thin, which conflicts with electrical isolation performance
One Axis needs to create the cooling capacity for all three so the size of this conductor is much greater than if it only needed to dissipate its own heat. Due to large conductors eddy current losses increase significantly.

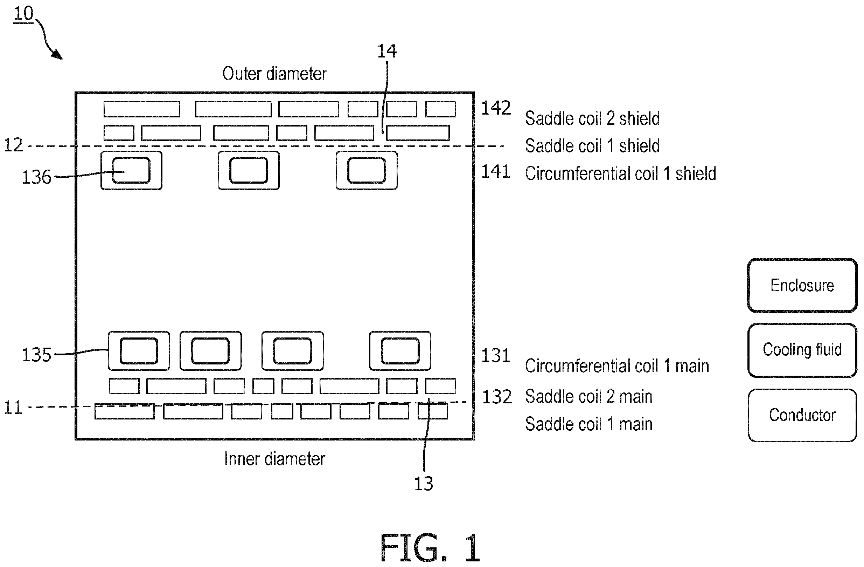

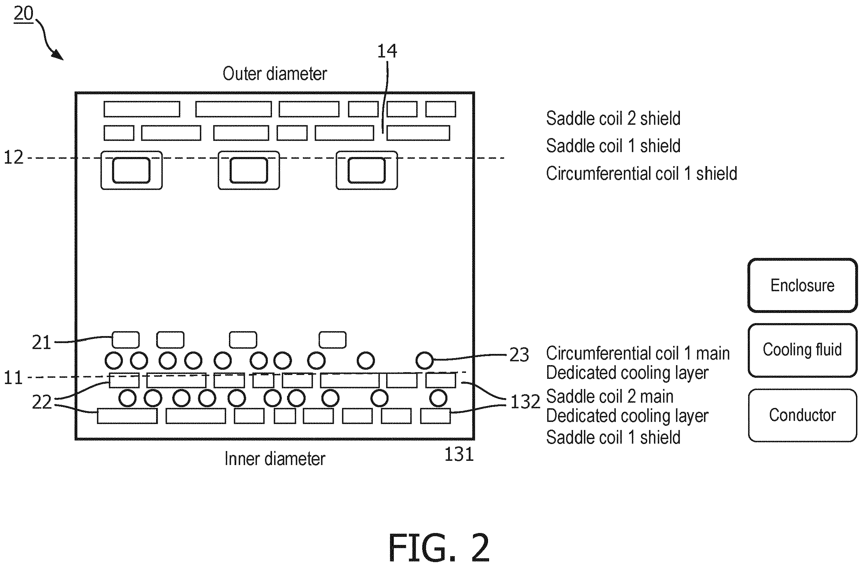

Fig. 2 shows part of a cross section in side elevation of a prior art gradient coil 10. In fact, Figure 1 shows only half of the longitudinal cross section of the cylindrical arrangement. Inner and outer cylindrical surfaces are indicated as 11 and 12. The surface area (saddle) field coil arrangement 132 proves for transverse gradient coil and solenoid type longitudinal field (z-coil) cols 131 generate gradient magnetic fields in the transverse and longitudinal directions. The surface area (saddle) shield coil arrangement 132 proves for transverse gradient coil and solenoid type longitudinal n (z-coil) cols 131 generate shielding gradient magnetic fields in the transverse and longitudinal directions. The longitudinal field and shield coils are formed from hollow conductors. Through the lumen 136 of these hollow conductors cooling fluid is passed to directly cool the longitudinal shield coils, that in turn indirectly cool the transverse field and shield gradient coils 13, 14.

### Detailed aspects of the invention

Separate cooling channels outside the conductors. In this example only the inner coils have separate cooling channels, but it can also be used on the outer coils, or on both.

### Pros

Easy to manufacture
Cooling density can be adjusted to the points where needed
Conductors have a small cross section so eddy current losses are minimal

### Cons

Separate cooling layer decrease the distance between the main coils and the shield coils. Also the more inward inner coils are further away from the patient. This together leads to poor electromagnetic performance.

If using a conducting layer, the risk of partial discharges also increases.

Additional layers will bring additional cost to the product. Dummy turns are needed to cool the saddle coils at places where there are no circumferential coils needed on the outer.

Fig. 2 shows p[art of a cross section of a side elevation gradient coil 20 of the invention with dedicated cooling channels 23 on the inner main coils. In particular the dedicated cooling channels are provided between the cylindrical layers of the saddle coils of the transverse gradient field coil system.

Using all hollow conductors for inner and outer coils

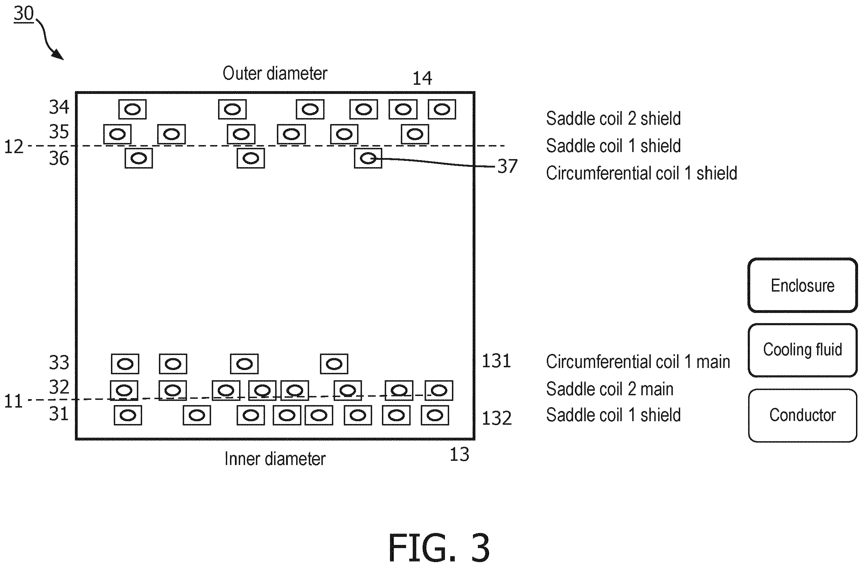

Fig. 3 shows part of a cross section of a side elevation of the gradient coil 30with an all hollow conductor design. The longitudinal 132 and transverse field coil arrangements 132 include hollow conductors 31,32 and 33. The longitudinal 141 and transverse shield coil arrangements 132 include hollow conductors 34,, 35 and 36. These hollow conductors each have a lumen 37 through which a cooling fluid is passed to individually cool the respective hollow conductors.

### Pros

Cooling is exactly where it needs to be, close to a conductor
No thermal conductivity requirements to the enclosure
Small conductors so eddy current losses are minimal

### Cons

Not cost effective because the hollow conductors are more expensive

The distance between the main coils and the shield coils is decreased (because shield coil stack is thicker), this leads to a lower efficiency.

The more outward inner coils are further away from the patient. This also leads to a lower efficiency.

The electromagnetic performance is compromised and the shield coils are cooled more than needed.

### Hybrid cooling

The concept of this invention, hybrid cooling: all inner main coils are hollow and directly cooled, on the outer shield coils only the circumferential coil is hollow and cools the saddle coils directly via conduction.

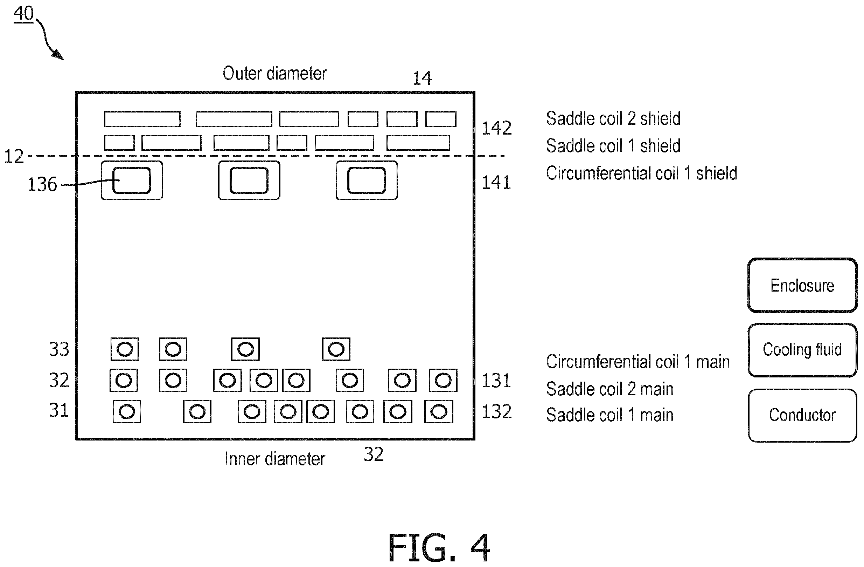

Fig. 4 shows part of a cross section of a side elevation of the gradient coil 40 of the gradient coil of the invention with a hybrid cooling layout. In this arrangement the longitudinal and transverse shield coils are configured as in the prior art configuration of Figure 1 in which the transverse shield coils are surface area (saddle) coils 142 that are indirectly cooled by the longitudinal shield coils 141 that have hollow conductors where cooling fluid is passed through their lumen 136.

This approach solves many issues with and optimises performance by looking at field densities and heat generation densities.

We will discuss the cons of the conventional designs compared to the proposed solution in more detail here below:

### Concept 1 only hollow circumferential conductors

Cooling is only in place were the circumferential coils are

In a gradient coil the current density isn't uniform so the circumferential conductors are sparsely wound in some locations. Cooling requirements have to be mitigated by dummy turns. Coils which do carry water but no electrical current so they don't contribute to the field.

The enclosing material needs to have a high thermal conductivity in order to transport heat from the saddle coils to the circumferential coils

No special fillers necessary, the high thermal conductivity is needed on the inner coil because there the heat generation is a factor higher. On the shield coils it is far less critical.

One axis needs to create the cooling capacity for all three so the size of this conductor is much greater than if it only needed to dissipate its own heat. Due to large conductors eddy current losses increase significantly.

On the inner only small conductors are used, on the outer we still have large conductors. However, the shield coils are in place in order to counter the main magnetic gradient field. Causing magnetic flux densities to be lower near the shield coil than the main coils.

### Concept 2 separate cooling channels outside the conductor

Separate cooling layer decrease the distance between the main coils and the shield coils. This leads to lower electromagnetic performance.

No separate cooling layers exist in the hybrid cooling.

If using a conducting layer, the risk of partial discharges also increases.

Not applicable because no separate cooling layer is used.

Additional layers will bring additional cost to the product.

Not applicable because no separate cooling layer is used.

### Concept 3 all hollow conductors

Not cost effective because the hollow conductors are more expensive

In the hybrid cooling layout, the expensive hollow saddle conductors are only used where they are required. This because the internal heat generation of the main coils is far greater than the outer coils.

Decrease the distance between the main coils and the shield coils because shield coil stack it thicker. This leads to a lesser electromagnetic performance.

They hybrid cooling mitigates this by using plate conductors on the outer coil making this a flat as possible.
shield coils are cooled more that it needs to be

No overcapacity on the outer coil with respect to cooling.

With more insight into the drawbacks of large conductors in the main coils, a new hybrid cooling was designed. The previous method was to put in large conductors in order to reduce the Ohmic resistance. This leads to a low resistivity at low frequency but high eddy current heating at higher frequencies. The hybrid design allows conductors in the main coil with small cross sections which is beneficial because there the magnetic flux density is high. In the shield coils the magnetic flux density is lower so larger plate conductors can be used without the risk of generating excessive eddy currents and heat.

This combines the high cooling capacity in the main coils where you need it and space saving plate conductors at locations where cooling isn't an issue. A high performance cooling build-up for gradient coils is designed. This is done in a way to ensure that most cooling is applied at locations that require it and at the same time improve the electromagnetic design.

In the example rectangular conductors ar used. This is by no means necessary both the shape of the conductor as well as the shape of the cooling channel can be modified. During the design build constraints do need to be taken into account like a minimal curve radius in order not to kink the conductor.

The technical advantage is acahieved due to the cooling performance supplied by having the cooling internally in combination with the small conductors in order to minimize eddy current effects. So making one of the main layer indirectly cooled would bring back a lot of the disadvantages. One way of designing a similar efficient design would be to place the cooling agent outside of the conductor but still letting it make contact. This is known from the international application WO2018/206370.

Any scan which is limited by the duty cycle of the gradient coil will benefit from this type of cooling. This is for example the case for fMRI scans with high frequency, high duty cycle EPI's. Other applications are for diffusion weighted MRI scans, which use high diffusion gradients. The efficiency gain from this hybrid design is beneficial for those scans (with same gradient amplifier power you can create higher gradient fields). Also the high currents generate a lot of heat and the hybrid design is able to cool this away efficiently.

## Claims

1. A shielded gradient coil (10) assembly to generate a gradient magnetic field, the assembly comprising
- a plurality of radially inner (11) and outer (12) coaxial cylindrical surfaces
- a gradient field coil arrangement (13) on the radially inner cylindrical surfaces including
- a longitudinal gradient field coil system (131) having one or more axial circumferential electrically conducting hollow z-field windings having a smaller transverse cross-section,
- a transverse gradient field coil system(132) having hollow (x,y)-field electrical conductors having a smaller transverse cross-section and arranged as saddle coils on the surfaces of the inner cylindrical surfaces,
- a gradient shield coil arrangement (14) on the radially outer cylindrical surfaces including
- a longitudinal gradient shield coil system (141) having one or more axial circumferential electrically conducting hollow z-shield windings (135) having a larger transverse cross-section,
- a transverse gradient shield coil system (142) having solid electrical conductors arranged as saddle coils on the surfaces of the outer cylindrical surfaces.

2. A shielded gradient coil assembly to generate a gradient magnetic field, the assembly comprising
- a plurality of radially inner (11) and outer (12) coaxial cylindrical surfaces
- a gradient field coil arrangement (13) on the radially inner cylindrical surfaces including
- a longitudinal gradient field coil system (131) having one or more axial circumferential electrically conducting solid z-field windings (21) having a smaller transverse cross-section,
- a transverse gradient field coil system (132) having solid (x,y)-field electrical conductors (22) having a smaller transverse cross-section and arranged as saddle coils on the surfaces of the inner cylindrical surface
- electrically insulating cooling channels (23) arranged between the solid z-field windings and the solid (x,y)-field windings, in particular between the respective inner cylindrical surfaces that carry the solid z-field windings and the solid (x,y)-field windings
- a gradient shield coil arrangement (14) on the radially outer cylindrical surfaces including
- a longitudinal gradient shield coil system (141)having one or more axial circumferential electrically conducting hollow z-shield windings having a larger transverse cross-section
- a transverse gradient shield coil system (142) having solid electrical conductors arranged as saddle coils on the surfaces of the outer cylindrical surfaces.

3. A shielded gradient coil assembly as claimed in Claim 1, wherein the longitudinal gradient shield coil system's electrical conductors (141) are in thermal correspondence with the transverse gradient shield coil system's surface area electrical conductors (142).

4. A shielded gradient coil assembly as claimed in Claim 1 or 2, wherein the transverse gradient shield coil system (132) has two radially offset sets of surface area electrical conductors for generating shielding gradient magnetic field in respective transverse orientations positioned radially outward relative to the longitudinal gradient shield coil system (131).

5. A shielded gradient coil assembly as claimed in any one of the preceding Claims, wherein the z-field windings (131) of the gradient field coil system are located radially inward relative to the surface area electrical conductors of the transverse gradient field coil system (132).

6. A shielded gradient coil assembly as claimed in any Claim 3, wherein
- the surface area electrical conductors for generating shielding gradient magnetic field in a first transverse orientation is radially outward from the surface area electrical conductors for generating shielding gradient magnetic field in a second transverse orientations and
- the longitudinal gradient field coil system has two radially offset sets of hollow (x,y)-field electrical conductors and the set of hollow (x-y)-field electrical conductors for generating the gradient magnetic field in the second transverse orientation is positioned radially outward form the set of hollow (x-y)-field electrical conductors for generating gradient magnetic field in the first transverse orientation.

7. A magnet system comprising a set of field coils to generate a uniform static magnetic field in the magnet system's examination zone and a gradient coil assembly of any one of Claims 1 to 5.
